Europäisches Patentamt

European Patent Office

Office européen des brevets

(19)

(11) Publication number : **0 486 182 A1**

(12) **EUROPEAN PATENT APPLICATION**

(21) Application number : **91310045.9**

(22) Date of filing : **30.10.91**

(51) Int. Cl.$^5$ : **C04B 35/00,** C01G 9/02, C23C 14/34, C23C 14/08

(30) Priority : **15.11.90 JP 307009/90**
**05.04.91 JP 99816/91**

(43) Date of publication of application :
**20.05.92 Bulletin 92/21**

(84) Designated Contracting States :
**DE FR GB**

(71) Applicant : **Tosoh Corporation**
**4560, Kaisei-cho**
**Shinnanyo-shi, Yamaguchi-ken (JP)**

(72) Inventor : **Ogawa, Nobuhiro**
**10-10, Jogaoka 2-chome**
**Tokuyama-shi, Yamaguchi (JP)**
Inventor : **Yoshimura, Ryoji**
**6-10, Miyanomae 2-chome**
**Shinnanyo-shi, Yamaguchi (JP)**
Inventor : **Mori, Takashi**
**15-4-404, Doi 2-chome**
**Shinnanyo-shi, Yamaguchi (JP)**

(74) Representative : **Kearney, Kevin David**
**Nicholas et al**
**KILBURN & STRODE 30 John Street**
**London, WC1N 2DD (GB)**

(54) **Zinc oxide sintered body, and production and application thereof.**

(57) A sintered zinc oxide film having a good uniformity is formed by sputtering wherein a zinc oxide sintered body having a (002) crystal orientation larger than the (101) crystal orientation and a density of at least 4.5 g/cm$^3$ is used as a target. The zinc oxide sintered body preferably contains an element having a positive valency of at least 3 and has a resistivity of not larger than 1 ohm·cm. The zinc oxide sintered body is prepared by neutralizing an aqueous sulfuric acid solution of zinc with ammonia, calcining the thus-formed precipitate, and sintering the calcined precipitate at a temperature of at least 1,300°C. An oxide or aqueous sulfuric acid solution of the above element may be incorporated in the zinc solution ; or an oxide of the above element may be incorporated in the calcined precipitate.

FIG. 3

EXAMPLE 2

COMPARATIVE
EXAMPLE I

EP 0 486 182 A1

This invention relates to a sintered body composed of zinc oxide or comprising zinc oxide as the main ingredient (hereinafter referred to as "zinc oxide sintered body"), and also to the production and application thereof. More particularly, this invention relates to a high-density zinc oxide sintered body having a high crystal orientation, a process for the preparation thereof, a sputtering target (hereinafter referred to as "target") capable of providing a uniform film composed of zinc oxide or comprising zinc oxide as the main ingredient (hereinafter referred to as "zinc oxide film"), and a process for making this zinc oxide film.

The top industrial use of the zinc oxide film is a transparent electroconductive film, and moreover, the zinc oxide film is industrialy used as a piazoelectric film and a surface elastic wave filter.

There is now an increasing demand for a transparent electrocondinctive film as a transparent electrode of a solar cell or display equipment, or as an antistatic electroconductive coating. As materials for a transparent electroconductive film, there can be mentioned indium oxide (ITO) doped with tin as an impurity, tin oxide doped with antimony, and other metal oxide materials. These transparent electroconductive films are usually made by sputtering metal oxides.

ITO has a high transparency and a film having a low electric resistance can be made from ITO, but indium is expensive and therefore ITO is economically disadvantageous. Moreover, ITO is chemically unstable and the field of application is restricted. Although antimony-doped tin oxide is cheap and is chemically relatively stable, the electric resistance is high and the material is not completely satisfactory.

It has recently be reported that a transparent electroconductive film having a low electric resistance and a good transparency can be obtained by sputtering a sintered body comprising zinc oxide as the main ingredient and being doped with aluminum or the like as an impurity (see, for example, J. Appl. Phys., 55, (4), 15 Feb., 1988, page 1029). Since zinc oxide is cheap, chemically stable and has a good transparency and electroconductivity, zinc oxide attracts attention as a good transparent electroconductive material that will be used instead of ITO and the like.

Nevertheless, conventional zinc oxide films have a conspicuously uneven electric resistance distribution, and it is very difficult to form a zinc oxide film covering a large area having a uniform and low electric resistance.

The present invention is intended to overcome the above-mentioned defect of the conventional technique, and a primary object of the present invention is to provide a sintered body exhibiting good characteristics when used as a target.

It now has been found that, if a film-forming sputtering is carried out by using as a target a high-density zinc oxide sintered body exhibiting a (002) crystal orientation larger than the (101) crystal orientation, a zinc oxide film having a good uniformity especially in electric resistance distribution and having good filtering characteristics can be obtained, whether the film-forming sputtering is carried out on a substrate parallel or inclined to the sputtering surface. Furthermore, it has been found that this sintered body can be prepared by adding ammonia to an aqueous sulfuric acid solution of zinc to yield a precipitate, calcining the precipitate and sintering the calcined powder at a temperature of at least 1,300°C.

Furthermore, it has been found that, if a zinc oxide sintered body made by sintering zinc oxide of a low resistivity having uniformly dispersed therein a different element having a positive valency of at least 3 is used as the target, a transparent electroconductive film having a more uniform electric resistance distribution can be obtained, and that this zinc oxide sintered body can be obtained by mixing an aqueous sulfuric acid solution of zinc with an oxide of an aqueous sulfuric acid solution of an element having a positive valency of at least 3, adding ammonia to the mixture to yield a precipitate, calcining the precipitate and sintering the calcined precipitate at a temperature of at least 1,300°C, or by adding ammonia to an aqueous sulfuric acid solution of zinc to yield zinc hydroxide, calcining the zinc hydroxide to yield zinc oxide, mixing the zinc oxide with an element having a positive valency of at least 3 and sintering the mixture at a temperature of at least 1,300°C.

As the element having a positive valency of at least 3 to be dispersed in zinc oxide, any element where a valency of at least 3 is retained as the state of the atomic valency can be used in the present invention. For example, at least one element selected from elements belonging to group IIIA, group IIIB, group IVA, group IVB, group VA, group VB, group VIA, group VIB, group VIIA, group VIII, the lanthanide group and the actinide group. The content of the electroconductive element is preferably 0.1 to 20 atomic %, more preferably 0.5 to 5 atomic %, based on zinc, because a zinc oxide sintered body having a very low electric resistance is obtained at this content of the electroconductive element.

The sintered body of the present invention and the process for the preparation thereof will now be described in detail.

With regard to the crystallinity of the zinc oxide sintered body of the present invention, the (002) crystal orientation must be larger than (101) crystal orientation. In conventional zinc oxide sintered bodies, the ratio (101)/(002) of the (101) crystal orientation to the (002) crystal orientation is about 100/44. In contrast, in the sintered body of the present invention, the (002) crystal orientation is larger than the (101) crystal orientation and the (002) crystal orientation occupies the majority of the crystal orientations of the sintered body. Namely, the (101)/(002) crystal orientation ratio of the zinc oxide sintered body of the present invention is preferably in the range of from about 0/100 to about 50/100. It is believed that the zinc oxide sintered body of the present invention, which has crystal orientation characteristics distinguishable from those of the conventional zinc oxide sintered bodies, is novel.

A zinc oxide film, formed by using the sintered body of the present invention as the target, exhibits a more enhanced (002) crystal orientation and can be a transparent electroconductive film having a high electroconductivity. In this sintered body in which a different element is dispersed, formation of a spinel oxide of zinc and the different element is drastically controlled, and the majority of the added element acts as the dopant in the sintered body.

This sintered body having a high (002) crystal orientation can be obtained by using as the starting material a hydroxide precipitated from an aqueous sulfuric acid solution of zinc by neutralization with ammonia. The hydroxide precipitated from the aqueous sulfuric acid solution of zinc is not a mere hydroxide but a hydroxide containing sulfuric acid radicals and ammonia. A zinc oxide powder and sintered body thereof having a high (002) crystal orientation can be obtained from this hydroxide.

In the preparation of the above-mentioned hydroxide, an aqueous sulfuric acid solution of zinc is neutralized with ammonia and the formed slurry is preferably aged for a long time to grow particles. The (002) crystal orientation of the hydroxide increases, with the result that the sintered body made from the hydroxide has a drastically increased (002) crystal orientation so that the (101)/(002) crystal orientation ratio is in the range of from about 0/100 to about 15/100. Moreover, by the above-mentioned aging, the particles are grown to plates having a size of 1 to 100 micrometres, especially 50 to 20 micrometres. The aging of the slurry can be accomplished by either allowing the slurry to stand or stirring the slurry. The aging time is preferably at least several hours, more preferably about 10 to about 100 hours.

The sintered body of the present invention containing a dispersed different element can be prepared by mixing the zinc oxide powder prepared according to the above-mentioned method with a powder of an oxide of the different element, and then sintering the mixture; or neutralizing a mixed solution comprising an oxide or aqueous sulfuric acid solution of the different element and an aqueous sulfuric acid solution of zinc with ammonia, calcining the precipitate, which is formed, and then sintering the calcined precipitate.

The sintered body of the present invention can be prepared by sintering the zinc oxide powder obtained by the above-mentioned method at a high temperature. The sintering temperature is desirably at least 1,300°C, and preferably about 1,400°C. Although the melting point of zinc oxide is 1,800°C, zinc oxide containing the electroconductive active element melts at such a high temperature. Therefore, the sintering is preferably carried out at a temperature not higher than 1,700°C, more preferably not higher than 1,450°C.

Preferably, the retention time at the sintering temperature in the sintering step is several hours to scores of hours, especially about 5 to about 20 hours. When the sintering is carried out at a high temperature as described above, even in air as the sintering atmosphere, a sintered body having a sufficiently low electric resistance can be obtained, but the sintering can be conducted in an inert gas atmosphere or in vacuum. In the case where the precipitate is calcined prior to the sintering, the calcination temperature is preferably 300 to 1,000°C and more preferably 500 to 800°C.

The sintered body of the present invention has a density of at least 4.5 g/cm³, and this high-density sintered body can be obtained by carrying out the sintering at a temperature of at least 1,300°C as described above. Since the sintered body of the present invention is prepared from particles precipitated from an aqueous sulfuric acid solution of zinc, the particle size of sintered particles is large and in many cases the density of sintered bodies is 4.5 to 5.3 g/cm³, and a target made from the sintered body having such a density has excellent performances.

A sintered body having a density lower than 4.5 g/cm³ involves problems concerning the electroconductivity and strength, but a sintered body having a density of at least 4.5 g/cm³ has a satisfactory electroconductivity and strength.

Since the particle size of the above-mentioned aged starting material powder is relatively large, most of sintered bodies made from this powder have a density of about 4.5 to about 5.3 g/cm³.

The resistivity of the zinc oxide sintered body having the different element dispersed therein, made by the above-mentioned process according to the present invention, is not larger than 1 ohm.cm, and in many cases not larger than 0.1 ohm.cm.

The invention can be put into practice in various ways and a number of specific embodiments will be described to illustrate the invention with reference to examples and to the accompanying drawings, in which:

Figures 1A, 1B and 1C are diagrams illustrating the sputtering apparatuses used in the present invention, wherein Figure 1-A shows an ordinary apparatus having a substrate in parallel to a target, Figure 1-B shows an apparatus having a substrate tilted to a target, and Figure 1-C shows an apparatus having a target, the surface of which is inclined or sloping rather than flat;

Figure 2 is a diagram showing x-ray diffraction patterns of sintered bodies made in accordance with examples of the present invention and comparative examples;

Figure 3 is a diagram showing filtering characteristic distributions of films formed by using as the target sintered bodies made in accordance with Example 2 of the present invention and Comparative Example 1;

Figure 4 is a diagram showing the resistivity distributions of films formed by using as the target sintered bodies made in accordance with Examples 6 and 8 of the present invention;

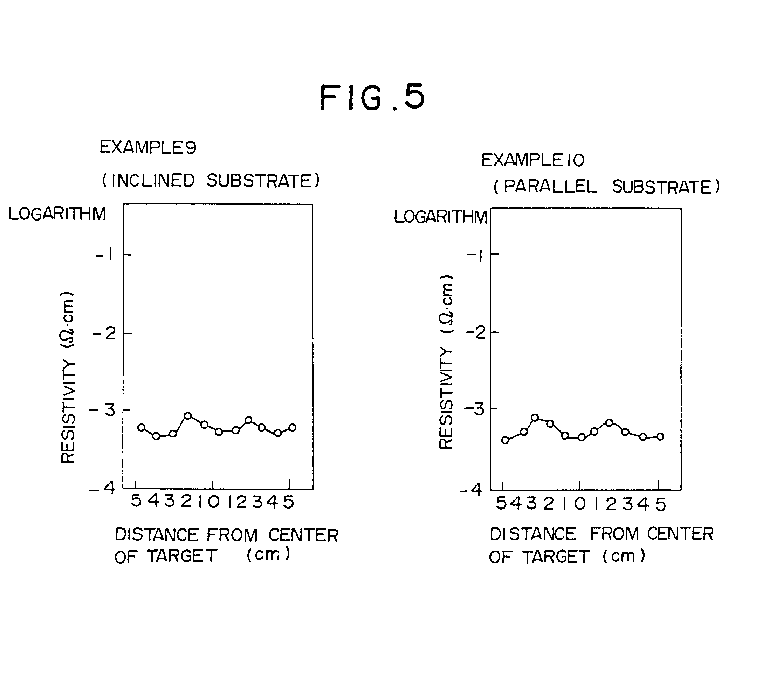

Figure 5 is a diagram showing the resistivity distributions of films formed by using as the target sintered bodies made in accordance with Examples 9 and 10 of the present invention;

Figure 6 is a diagram showing the resistivity distributions of films formed by using as the target sintered bodies made in accordance with Comparative Examples 3 and 4;

Figure 7 is a diagram showing an X-ray diffraction pattern of a sintered body made in accordance with Example 11 of the present invention; and

Figure 8 is a diagram showing the resistivity distribution of a transparent electroconductive film formed in accordance with Example 12 of the present invention.

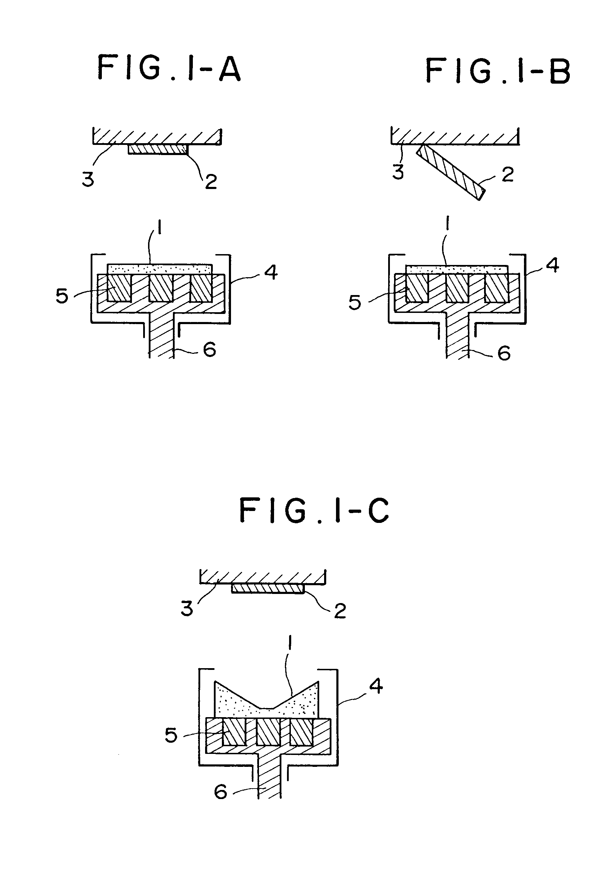

The process for making a transparent electroconductive film having a uniform filtering characteristic distribution or uniform resistivity distribution by using the target of the present invention will now be described with reference to Figure 1.

According to the customary sputtering process, as shown in Figure 1-A, a target 1 and a substrate 2 are arranged in parallel to confront each other. The target 1 is held on an electrode 6 through magnets 5, and the electrode 6 is surrounded by a counter electrode 4. The substrate 2 is held by a substrate holder 3. As described hereinbefore, if a zinc oxide film is made by using a target 1 of conventional composition (described below in the comparative Examples), the filtering characteristic distribution or resistivity distribution becomes uneven. Since the target of the present invention has a large (002) crystal orientation, by using the target having a composition of the present invention (as described in the Examples below) and the apparatus shown in Figure 1-A, the crystal orientation of the resulting film is controlled and the filtering characteristic distribution and resistivity distribution thereof is made more uniform. Furthermore, when a film is made on a parallel substrate by using the above-mentioned sintered body having an especially large (002) crystal orientation as the target and the apparatus shown in Figure 1-A, the obtained film has excellent uniformity.

A zinc oxide film having a filtering characteristic distribution and resistivity distribution of improved uniformity can also be made by carrying out the film-forming sintering while using a substrate 2 having a surface tilted relative to the sputtering surface of the target 1, as illustrated in Figures 1-B and 1-C.

For example, there can be adopted a process wherein a substrate 2 held in a substrate holder 1 is inclined while a target 1 is held horizontally on an electrode 6 as shown in Figure 1-B, and a process wherein the film-forming sputtering is carried out by using a target 1 having an inclined or sloping sputtering surface while a substrate 2 is held horizontally as shown in Figure 1-C. The inclination angle can be selected within a range from 0° up to 90° without any limitation. However, if the inclination angle exceeds 90°, it is apprehended that the film thickness will become uneven, and preferably, the inclination angle is up to 60°.

A target having an inclined sputtering surface can be prepared by a polishing method, a cast molding method or the like, but in view of ease of controlling the shape, a cast molding method is preferable.

The present invention will now be described with reference to the following examples that by no means limit the scope of the invention.

Example 1

A 1M aqueous solution of zinc sulfate having a pH value of 3 was neutralized with ammonia so that the pH value became 7, whereby a precipitate of zinc hydroxide was prepared. The obtained precipitate was calcined in air at 800°C to yield a zinc oxide powder. The zinc oxide powder was compression-molded in a press mold.

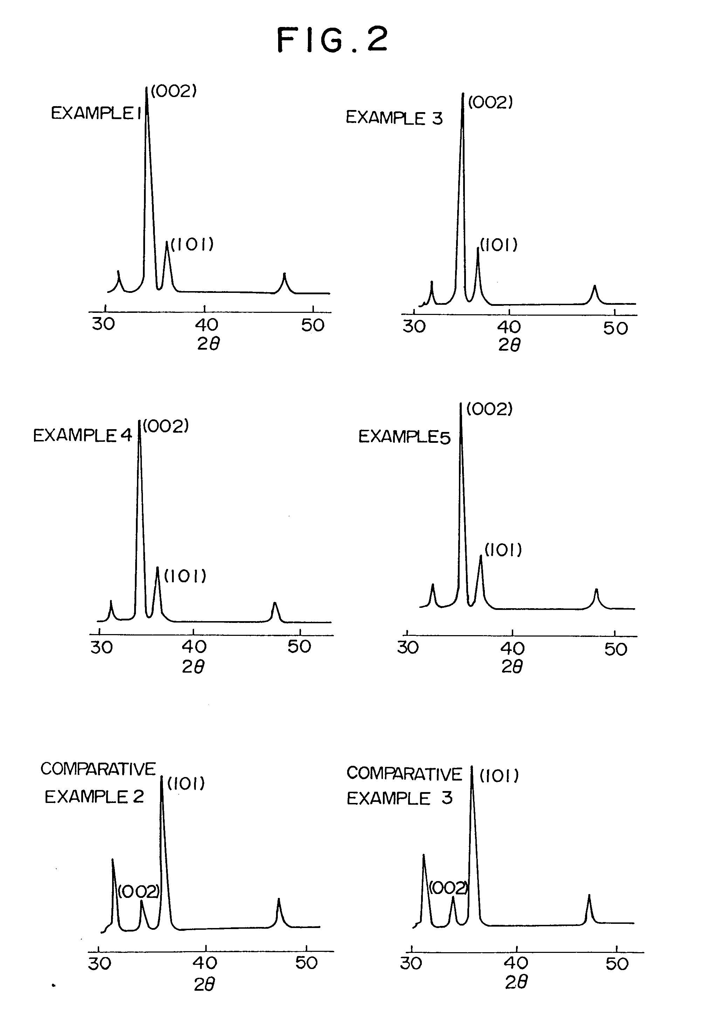

Since the powder-molded body contained sulfuric acid radicals and ammonia, the molded body was heated to 1,000°C over a period of about 40 hours to remove sulfuric acid. Then, the molded body was compressed by the cold isostatic pressure (CIP) molding method and sintered in air at 1,400°C. The obtained sintered body had a density of 5.3 g/cm³. The X-ray diffraction pattern of the sintered body is shown in Fig. 2. The sintered body exhibited a (002) crystal orientation.

Example 2

By using the sintered body prepared in Example 1, a zinc oxide film was formed on an inclined substrate 2 (the inclination degree was 30°) shown in Figure 1-B under the following conditions.

Film-forming method: RF magnetron sputtering ( 13. 56 MHz)
Target: zinc oxide sintered body having a diameter of 80 mm
Target-substrate distance: 45 mm
Target substrate angle: inclined by 30°
Gas (pressure): pure argon (1 Pa)
Substrate temperature: 200°C
Substrate: polycrystalline silicon wafer
Applied power: 2 W/cm²
Film thickness: 5,000 angstroms

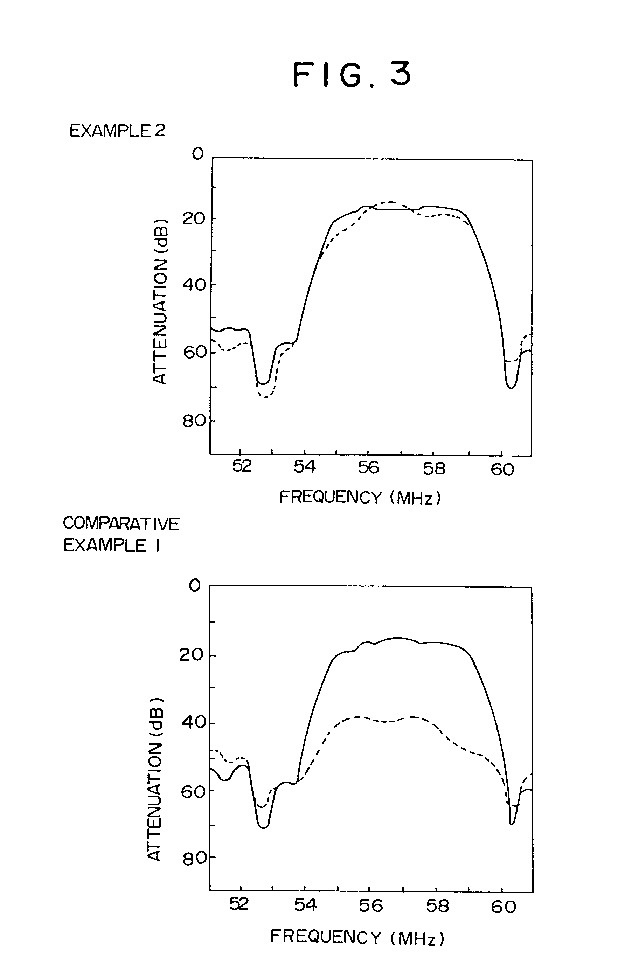

The filtering characteristics of the portion of the film just above the erosion area of the target are shown by a broken line in Fig. 3, and those of the portions of the film just above the center and periphery of the target are shown by a solid line in Fig. 3.

As is seen from Fig. 3, the filtering characteristics of the film were uniform irrespectively of the sputtering position.

Example 3

A mixed aqueous solution containing 1M zinc sulfate and 0.015M aluminum sulfate and having a pH value of 3 was neutralized with ammonia to a pH value of 7 to yield a hydroxide coprecipitate. The hydroxide coprecipitate was calcined in air at 800°C to yield a mixed oxide powder. The mixed oxide powder was compression-molded by a press mold.

Since the powder-molded body contained sulfuric acid radicals and ammonia, the molded body was heated to 1,000°C over a period of about 40 hours to remove sulfuric acid. The molded body was compressed by the CIP method and sintered in air at 1,400°C. The obtained sintered body had a density of 5.2 g/cm³ and a resistivity of 0.1 ohm·cm.

The X-ray diffraction pattern of the sintered body is shown in Fig. 2. The sintered body exhibited a (002) crystal orientation.

Example 4

A sintered body was prepared in the same manner as described in Example 3 except that 0.015M of aluminum oxide was used instead of 0.015M of aluminum sulfate. The obtained sintered body had a density of 5.2 g/cm³ and a resistivity of 0.1 ohm·cm.

The X-ray diffraction pattern of the obtained sintered body is shown in Fig. 2. The sintered body exhibited a (002) crystal orientation.

Example 5

A 1M aqueous solution of zinc sulfate having a pH value of 3 was neutralized with ammonia to a pH value of 7 to yield zinc hydroxide. The obtained zinc hydroxide precipitate was calcined in air at 800°C to yield a zing oxide powder. The obtained zinc oxide powder was mixed with an aluminum oxide powder and the powder mixture was compression-molded by a press mold.

Since the powder-molded body contained sulfuric acid and ammonia, the molded body was heated to 1,000°C over a period of about 40 hours to remove sulfuric acid. Then, the molded body was pressed by the CIP method and sintered in air at 1,400°C. The obtained sintered body had a density of 5.1 g/cm³ and a resistivity of 0.1 ohm· cm.

The X-ray diffraction pattern of the sintered body is shown in Fig. 2. The sintered body exhibited a (002) crystal orientation.

Example 6

A transparent electroconductive film was formed by the DC magnetron sputtering method using the sintered body prepared in Example 3 as the target.

Namely, an aluminum-doped transparent electroconductive film was formed on a parallel substrate as shown in Fig. 1 under the following conditions.

Film-forming method: DC magnetron sputtering

Target: zinc oxide sintered body having a diameter of 80 mm

Target-substrate distance: 45 mm

Target-substrate angle: parallel or inclined by 30°

Gas (pressure): pure argon (1 Pa)

Substrate temperature: 25°C

Substrate: Glass (#7079 supplied by Corning Co.)

Applied power: 2 W/cm³

Film thickness: 5,000 angstroms

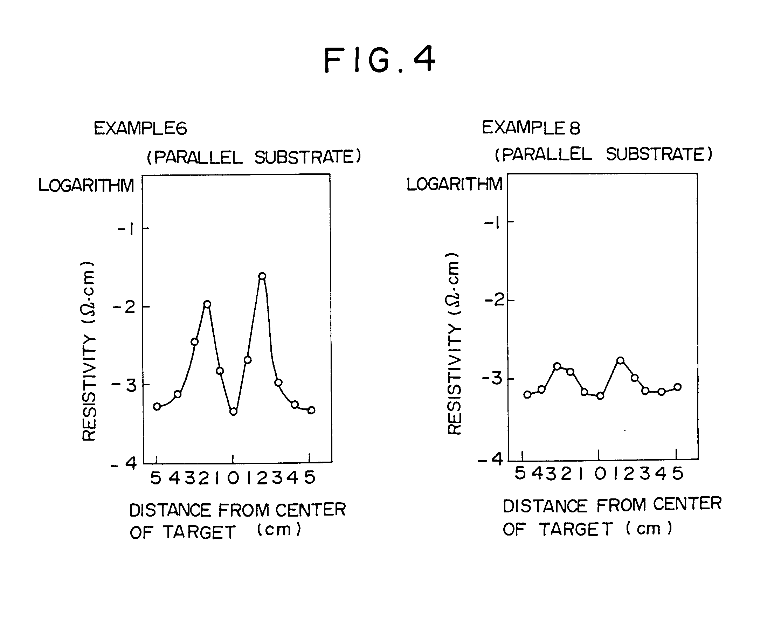

The resistivity distribution of the obtained transparent electroconductive film is shown in Fig. 4. Thus, it was confirmed that a transparent electroconductive film having a relatively uniform and low resistivity was obtained.

Example 7

A mixed aqueous solution of 1M zinc sulfate and 0.015M aluminum sulfate and having a pH value of 3 was neutralized with ammonia to a pH value of 7 to yield a hydroxide coprecipitate. The obtained hydroxide coprecipitate was calcined in air at 800°C to yield a mixed oxide powder. The oxide powder was molded by the slip casting (slurry casting) method so that the portion to be substantially sputtered was inclined by about 30°.

Since the powder-molded body contained sulfuric acid radicals and ammonia, the molded body was heated to 1,000°C over a period of about 40 hours to remove sulfuric acid. Then, the calcined body was pressed by the CIP method and sintered in air at 1,400°C. The obtained sintered body had a density of 5.2 g/cm³ and a resistivity of 0.1 ohm·cm.

Example 8

By using the sintered body obtained in Example 7 as the target, a transparent electroconductive film was formed on a parallel substrate under the same conditions as recited in Example 6 by the apparatus shown in Fig. 1-A.

The resistivity distribution of the obtained transparent electroconductive film is shown in Fig. 4. It was confirmed that a transparent electroconductive film having a uniform and low resistivity over a broad range was obtained.

Example 9

By using the sintered body prepared in Example 3 as the target, a transparent electroconductive film was formed on an inclined substrate (the inclination angle was 30°) by the apparatus shown in Figure 1-B under the same sputtering conditions as recited in Example 6.

The resistivity distribution of the obtained transparent electroconductive film is shown in Figure 4. Thus, it was confirmed that a transparent electroconductive film having a uniform and low resistivity over a broad range was obtained.

Example 10

By using the sintered body prepared in Example 3 as the target, a transparent electroconductive film was formed on a parallel substrate under the same sputtering conditions as recited in Example 6 by the apparatus shown in Figure 1-A.

The resistivity distribution of the obtained transparent electroconductive film is shown in Figure 4. Thus, it was confirmed that a transparent electroconductive film having a uniform and low resistivity over a broad range was obtained.

Example 11

A mixed aqueous solution containing 1M zinc sulfate and 0.015M aluminum sulfate having a pH value of 3 was neutralized with ammonia to a pH value of 7 to yield a hydroxide coprecipitate. The slurry of the hydroxide coprecipitate was stirred for 60 hours and aged. The aged hydroxide was recovered by filtration, dried and calcined in air at 900°C to prepare an oxide powder. The oxide powder was compression-molded by a press mold.

Then the powder-molded body was compressed by the CIP method and sintered in air at 1,400°C. The obtained sintered body had a density of 4.8 g/cm$^3$ and a resistivity of 0.1 ohm·cm.

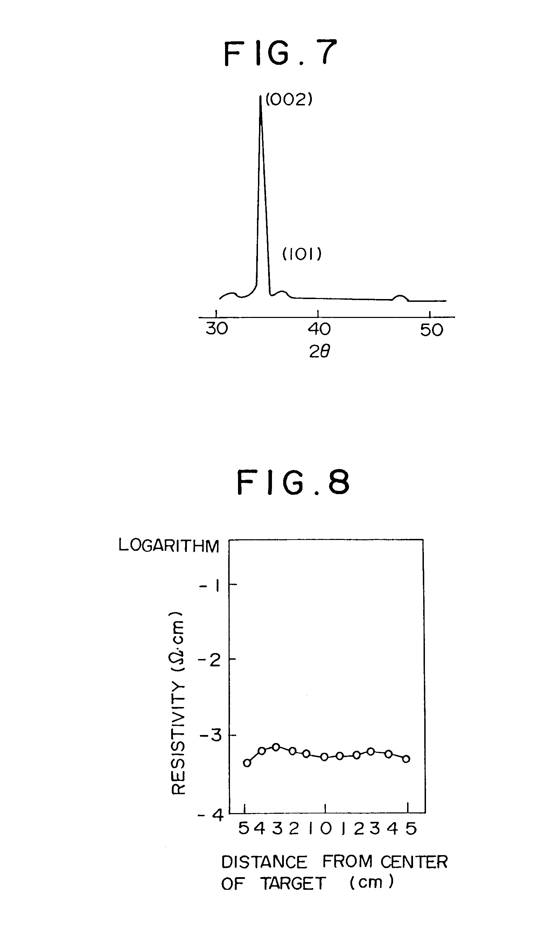

The X-ray diffraction pattern of the obtained sintered body is shown in Figure 7. The sintered body had a very high (002) crystal orientation.

Example 12

By using the sintered body prepared in Example 11 as the target, a transparent electroconductive film was formed on a parallel substrate under the same sputtering conditions as recited in Example 6 by the apparatus shown in Figure 1-A by the DC magnetron sputtering method.

The resistivity distribution of the obtained transparent electroconductive film is shown in Figure 8. Thus, it was confirmed that a film having a substantially uniform resistivity distribution was obtained.

Comparative Example 1

Commercially available zinc oxide of the reagent class was compression-molded, and the obtained molded body was sintered at 1,400°C. The obtained sintered body had a low density, i.e., density of 4.5 g/cm$^3$ and a crystal orientation ratio (101)/(002) of 100/40.

By using the obtained sintered body as the target, a zinc oxide film was formed on an inclined substrate (the inclination angle was 30°) under the same sputtering conditions as recited in Example 2 by the apparatus shown in Figure 1-B. The filtering characteristics of the portion just above the erosion area of the obtained film are shown by a broken line in Figure 3, and those of the portions just above the center and periphery of the target are shown by a solid line in Figure 3.

As is seen from Figure 3, the filtering characteristics greatly changed according to the particular area of the sputtering, and at the portion just above the erosion area of the target, the filtering property was especially low.

Comparative Example 2

A mixed aqueous solution containing 1M zinc chloride and 0.015M aluminum chloride and having a pH value of 3 was neutralized with ammonia to a pH value of 7 to yield a hydroxide coprecipitate. The hydroxide coprecipitate was calcined in air at 800°C to yield an oxide powder, and the oxide powder was molded and sintered in air at 1,400°C.

The obtained sintered body had a low density, i.e., a density of 3.9 g/cm$^3$, and a resistivity of 200 k-ohm·cm. The X-ray diffraction pattern of the sintered body is shown in Figure 2. The sintered body showed no (002) crystal orientation.

Comparative Example 3

A commercially available zinc oxide powder was mixed with aluminum oxide at a weight ratio of 98/2 (i.e., a molar ratio of 97/3), and the mixture was compression-molded by a press mold and sintered in air at 1,400°C.

The obtained sintered body had a density of 5.4 g/cm$^3$ and a resistivity of 0.1 ohm·cm. The X-ray diffraction pattern of the sintered body is shown in Figure 2. The sintered body showed no (002) crystal orientation.

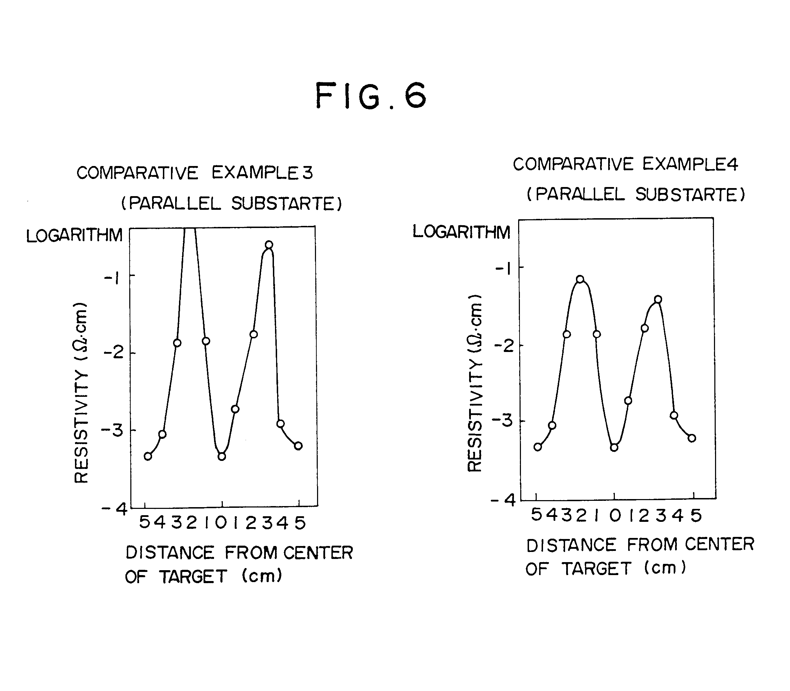

By using this sintered body as the target, a different element-doped transparent electroconductive film was formed on a parallel substrate under the same sputtering conditions as recited in Example 6 by the apparatus shown in Figure 1-A. The resistivity distribution of the film is shown in Figure 6. Thus, it was confirmed that the resistivity distribution of the film was not uniform.

Comparative Example 4

By using the same sintered body as used in Comparative Example 3 as the target, an aluminum-doped transparent electroconductive film was formed on a parallel substrate under the same sputtering conditions as recited in Example 6 by the apparatus shown in Figure 1-A. The resistivity distribution of the obtained film is shown in Figure 6. Thus, it was confirmed that the film had an uneven resistivity distribution.

As is seen from the foregoing description, the sintered body of the present invention exhibits a (002) crystal orientation, and a transparent electroconductive film formed by the film-forming sputtering using this sintered body as the target has a uniform quality.

**Claims**

1. A zinc oxide sintered body having a (002) crystal orientation larger than the (101) crystal orientation and a density of at least 4. 5 g/cm$^3$.

2. A zinc oxide sintered body as claimed in Claim 1 characterised in that it has dispersed therein an element having a positive valency of at least 3 and has a resistivity of not larger than 1 ohm.cm.

3. A process for the preparation of a zinc oxide sintered body, characterised in that it comprises neutralizing an aqueous sulfuric acid solution of zinc with ammonia, calcining the thus-formed precipitate, and sintering the calcined precipitate at a temperature of at least 1,300°C.

4. A process for the preparation of a zinc oxide sintered body, characterised in that it comprises neutralizing a mixed solution comprising an oxide or aqueous sulfuric acid solution of an element having a positive valency of at least 3 and an aqueous sulfuric acid solution of zinc with ammonia, calcining the thus-formed precipitate, and sintering the calcined precipitate at a temperature of at least 1,300°C.

5. A process for the preparation of a zinc oxide sintered body, characterised in that it comprises neutralizing an aqueous sulfuric acid solution of zinc with ammonia, calcining the thus-formed zinc hydroxide to produce zinc oxide, mixing the oxide with an oxide of an element having a positive valency of at least 3, and sintering the mixture at a temperature of at least 1,300°C.

6. A sputtering target comprising a zinc sintered body having a (002) crystal orientation larger than the (101) crystal orientation and a density of at least 4.5 g/cm$^3$.

7. A sputtering target as claimed in Claim 6, characterised in that it has a sputtering surface inclined relative to the substrate surface.

8. A sputtering target as claimed in Claim 6 or Claim 7, characterised in that it has a resistivity not larger than 1 ohm.cm.

9. A sputtering target comprising a zinc oxide body characterised in that it is made by a process as claimed in Claim 3, 4 or 5.

10. A process for making a zinc oxide film, which comprises carrying out film-forming sputtering on a substrate by using a sputtering target having a sputtering surface inclined relative to the substrate surface or parallel to the substrate surface characterised in that the sputtering target is as claimed in Claim 6, 7, 8 or 9.

# FIG.I-A

# FIG.I-B

# FIG.I-C

# FIG.2

EXAMPLE1  (002)  (101)
30  40  50
2θ

EXAMPLE 3  (002)  (101)
30  40  50
2θ

EXAMPLE 4  (002)  (101)
30  40  50
2θ

EXAMPLE5  (002)  (101)
30  40  50
2θ

COMPARATIVE EXAMPLE 2  (101)  (002)
30  40  50
2θ

COMPARATIVE EXAMPLE 3  (101)  (002)
30  40  50
2θ

# FIG. 3

EXAMPLE 2

COMPARATIVE
EXAMPLE I

# F I G. 4

EXAMPLE 6

(PARALLEL SUBSTRATE)

LOGARITHM

EXAMPLE 8

(PARALLEL SUBSTRATE)

LOGARITHM

DISTANCE FROM CENTER
OF TARGET (cm)

DISTANCE FROM CENTER
OF TARGET (cm)

EP 0 486 182 A1

# FIG.5

EXAMPLE9

(INCLINED SUBSTRATE)

EXAMPLE10

(PARALLEL SUBSTRATE)

LOGARITHM

RESISTIVITY ($\Omega \cdot cm$)

-1

-2

-3

-4

5 4 3 2 1 0 1 2 3 4 5

DISTANCE FROM CENTER
OF TARGET (cm)

LOGARITHM

RESISTIVITY ($\Omega \cdot cm$)

-1

-2

-3

-4

5 4 3 2 1 0 1 2 3 4 5

DISTANCE FROM CENTER
OF TARGET (cm)

EP 0 486 182 A1

# FIG.6

COMPARATIVE EXAMPLE 3
(PARALLEL SUBSTARTE)

COMPARATIVE EXAMPLE 4
(PARALLEL SUBSTARTE)

DISTANCE FROM CENTER
OF TARGET (cm)

DISTANCE FROM CENTER
OF TARGET (cm)

EP 0 486 182 A1

# FIG. 7

(002)

(101)

30          40          50

$2\theta$

# FIG. 8

LOGARITHM

-1

-2

RESISTIVITY ($\Omega \cdot cm$)

-3

-4

5 4 3 2 1 0 1 2 3 4 5

DISTANCE FROM CENTER
OF TARGET (cm)

14

EP 0 486 182 A1

European Patent
Office

**EUROPEAN SEARCH REPORT**

Application Number

EP    91 31 0045

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| Y | EP-A-0 354 769 (TOSOH CORP.) 14 February 1990<br>* page 4, line 34 - page 7, line 2; claims 1-12 *<br>--- | 1-10 | C04B35/00<br>C01G9/02<br>C23C14/34<br>C23C14/08 |
| Y | JOURNAL OF THE AMERICAN CERAMIC SOCIETY.<br>vol. 72, no. 10, October 1989, WESTERVILLE, OHIO, US<br>pages 2004 - 2008;<br>S. M. HAILE ET AL.: 'Aqueous Precipitation of Spherical Zinc Oxide Powders for Varistor Applications'<br>* page 2004, column 3 - page 2007, column 1 *<br>--- | 1-10 | |
| A | ZEITSCHRIFT FUR ANORGANISCHE CHEMIE.<br>vol. 134, 1924, LEIPZIG DD<br>pages 344 - 356;<br>R. FRICKE, T. AHRNOTS: 'über die Alterung des Zinkhydroxyds und über Alkalizinkate.'<br>* page 344 - page 348 *<br>--- | 1-3 | |
| A | DE-A-3 639 508 (RICOH CO., LTD.) 27 May 1987<br>* the whole document *<br>--- | 1,2,6-10 | TECHNICAL FIELDS SEARCHED (Int. Cl.5 ) |
| A | WORLD PATENTS INDEX LATEST<br>Week 8801,<br>Derwent Publications Ltd., London, GB;<br>AN 88-005330<br>& SU-A-1 310 913 (KUDRENKO I.A.) 15 May 1987<br>* abstract *<br>----- | 1-6 | C04B<br>C01G<br>C23C |

The present search report has been drawn up for all claims

| Place of search | Date of completion of the search | Examiner |
|---|---|---|
| THE HAGUE | 12 FEBRUARY 1992 | LUETHE H. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)

15